# EUROPÄISCHE PATENTANMELDUNG

(11) **EP 4 492 923 A1**
(43) Veröffentlichungstag der Anmeldung: **15.01.2025**
(21) Anmeldenummer: 23184582.7
(22) Anmeldetag: 11.07.2023
(51) Int. Cl.: H05K 1/02, H05K 1/16, H05K 1/14, G01L 1/04, G01M 5/00

(54) **SYSTEM UMFASSEND EINE FLACHBAUGRUPPE SOWIE FLACHBAUGRUPPEN**

(71) Anmelder: Siemens Aktiengesellschaft, 80333 München (DE)
(72) Erfinder: ZÖRNER, Boris, 07554 Gera (DE); BÜRGER, Dirk, 09221 Neukirchen (DE); LEIBELT, Jan, 09116 CHemnitz (DE)
(74) Vertreter: Siemens Patent Attorneys

(57) **Zusammenfassung**

Die Erfindung betrifft ein System (100) umfassend eine Flachbaugruppe (1), die eine Leiterplatte (2) aus elektrisch isolierendem Material, die auch als ein- oder mehrlagige Leiterplatte ausgebildet sein kann, einer Mehrzahl von aus einem elektrisch leitenden Material hergestellte Leiterbahnen (12), die an der Leiterplatte (2) angeordnet sind, und wenigstens einen an der Leiterplatte (2) positionierten Sensor (13) aufweist, und zumindest eine Sensorelektronik (14), die zur Auswertung der von dem wenigstens einen Sensor (13) bereitgestellten Sensorsignale ausgebildet ist, wobei die Leiterplatte (2) zumindest einen mit Ausnehmungen (8) versehenen, torsions- und biegefähigen Bereich (5) aufweist, und wobei der wenigstens eine Sensor (13) und die Sensorelektronik (14) dazu ausgelegt sind, eine Messgröße zu erfassen, die eine Auslenkung des torsions- und biegefähigen Bereiches (5) aus einer Ausgangsstellung repräsentiert, wobei es sich bei dem Material des wenigstens einen Sensors (13) um das elektrisch leitende Material der Leiterbahnen (12) handelt. Ferner betrifft die Erfindung eine Flachbaugruppe (1) zur Herstellung eines solchen Systems (100).

## Beschreibung

Die Erfindung betrifft ein System umfassend eine Flachbaugruppe, die eine Leiterplatte aus elektrisch isolierendem Material, die auch als ein- oder mehrlagige Leiterplatte ausgebildet sein kann, einer Mehrzahl von aus einem elektrisch leitenden Material hergestellte Leiterbahnen, die an der Leiterplatte angeordnet sind, und wenigstens einen an der Leiterplatte positionierten Sensor aufweist, und zumindest eine Sensorelektronik, die zur Auswertung der von dem wenigstens einen Sensor bereitgestellten Sensorsignale ausgebildet ist, wobei die Leiterplatte zumindest einen mit Ausnehmungen versehenen, torsions- und biegefähigen Bereich aufweist, und wobei der wenigstens eine Sensor und die Sensorelektronik dazu ausgelegt sind, eine Messgröße zu erfassen, die eine Auslenkung des torsions- und biegefähigen Bereiches aus einer Ausgangsstellung repräsentiert. Ferner betrifft die vorliegende Erfindung eine Flachbaugruppe zur Herstellung eines solchen Systems.

Flachbaugruppen, die auch als Platinen bezeichnet werden, sind im Stand der Technik in unterschiedlichen Ausgestaltungen bekannt. Sie umfassen eine als Träger für die elektrischen Komponenten und Leiterbahnen dienende Leiterplatte aus elektrisch isolierendem Material, beim dem es sich bei preiswerten Varianten um Hartpapier und bei teureren Varianten um glasfaserverstärkten Kunststoff (GFK) oder FR4 handeln kann. Bei der Herstellung einer Flachbaugruppe wird die Oberfläche der Leiterplatte vollständig mit einem elektrisch leitenden Material beschichtet, beispielsweise mit Kupfer. Anschließend werden Teile dieser Beschichtung wieder entfernt, so dass nur noch die gewünschten Leiterbahnen verbleiben. Zu diesem Zweck wird beispielsweise ein Fotolack auf die Beschichtung aufgetragen und dann eine die gewünschten Leiterbahnen bedeckende Maske auf dem Fotolack positioniert, woraufhin der Fotolack belichtet wird. Die belichteten Bereiche des Fotolacks werden löslich und mit einer geeigneten Lösung weggeätzt. In einem weiteren Schritt kann eine Schutzschicht beispielsweise aus Zinn, Nickel oder Gold aufgetragen werden. Im Anschluss wird ein so genannter Lötstopplack aufgetragen, woraufhin die Leiterplatte mit den elektronischen Bauteilen bestückt werden kann. Anstelle des Ätzens können auch Stanzverfahren oder Laserverfahren zum Einsatz kommen. Die Leiterplatte kann auch mehrschichtig aufgebaut sein, also mehrere übereinander angeordnete Leiterplattenschichten aufweisen. Dies hat den Vorteil, dass nicht nur die Ober- und Unterseite der Leiterplatte sondern auch die Oberflächen der mittleren Leiterplattenschichten mit Leiterbahnen und elektronischen Komponenten bestückt werden können. Eine elektrische Verbindung von Leiterbahnen, die in unterschiedlichen Ebenen der Leiterplatte angeordnet sind, erfolgt dann normalerweise über sogenannte Durchkontaktierungen.

Ferner ist es bekannt, Flachbaugruppen mit Sensoren und einer zugehörigen Sensorelektronik zu versehen. Hierbei wird normalerweise auf handelsübliche Komponenten zurückgegriffen, die dann als separate Komponenten in geeigneter Weise auf der Leiterplatte montiert werden. Als Sensoren kommen beispielsweise Dehnungsmessstreifen (DMS), kapazitive Sensoren, induktive Sensoren, Kontaktschalter oder dergleichen in Frage.

Die Firma Würth Elektronik hat eine Flachbaugruppe mit aufgetragenem Sensor entwickelt. Bei dieser Flachbaugruppe weist die Leiterplatte einen nach Art eines Biegebalkens ausgebildeten elastischen Bereich auf, auf dem ein Sensor in Form eines Dehnungsmessstreifens angeordnet ist, der durch Aufdrucken einer speziellen Leitpolymerpaste hergestellt wird.

Ausgehend von diesem Stand der Technik ist es eine Aufgabe der vorliegenden Erfindung, ein System der eingangs genannten Art sowie eine zur Herstellung eines solchen Systems vorgesehene Flachbaugruppe mit alternativem Aufbau zu schaffen.

Zur Lösung dieser Aufgabe schafft die vorliegende Erfindung ein System umfassend eine Flachbaugruppe, die eine Leiterplatte aus elektrisch isolierendem Material, die auch als ein- oder mehrlagige Leiterplatte ausgebildet sein kann, einer Mehrzahl von aus einem elektrisch leitenden Material hergestellte Leiterbahnen, die an der Leiterplatte angeordnet sind, und wenigstens einen an der Leiterplatte positionierten Sensor aufweist, und zumindest eine Sensorelektronik, die zur Auswertung der von dem wenigstens einen Sensor bereitgestellten Sensorsignale ausgebildet ist, wobei die Leiterplatte zumindest einen mit Ausnehmungen versehenen, torsions- und biegefähigen Bereich aufweist, und wobei der wenigstens eine Sensor und die Sensorelektronik dazu ausgelegt sind, eine Messgröße zu erfassen, die eine Auslenkung des torsions- und biegefähigen Bereiches aus einer Ausgangsstellung repräsentiert, dadurch gekennzeichnet, dass es sich bei dem Material des wenigstens einen Sensors um das elektrisch leitende Material der Leiterbahnen handelt. Somit ist es möglich, den wenigstens einen Sensor gemeinsam mit den Leiterbahnen bei der Herstellung der Flachbaugruppe zu fertigen und entsprechend Fertigungsschritte einzusparen, wodurch sich die Herstellungskosten der Flachbaugruppe und damit des Systems senken lassen.

Gemäß einer Ausgestaltung der vorliegenden Erfindung erstreckt sich der torsions- und biegefähige Bereich von einer ersten Seitenkante der Leiterplatte zu einer gegenüberliegenden zweiten Seitenkante der Leiterplatte, insbesondere vollständig von einer ersten Seitenkante der Leiterplatte zu einer zweiten gegenüberliegenden Seitenkante der Leiterplatte, und trennt bevorzugt zwei starre Bereiche der Leiterplatte voneinander. Ist die leiterplatte mit elektronischen Bauteilen bestückt, so sind diese dann bevorzugt an den starren Bereichen angeordnet.

Die Ausnehmungen bilden bevorzugt eine Mehrzahl von sich geradlinig zwischen der ersten Seitenkante und der zweiten Seitenkante, insbesondere senkrecht zu diesen, teilweise fluchtend miteinander und teilweise parallel zueinander erstreckenden Stegen, die über Zwischenstege miteinander verbunden sind, wobei Gruppen von Zwischenstegen miteinander fluchten. Auf diese Weise wird eine besonders biege- und torsionsfähige Struktur erzielt.

Gemäß einer Ausgestaltung der vorliegenden Erfindung ist innerhalb des torsions- und biegefähigen Bereiches zumindest ein Sensor in Form von Leiterzügen vorgesehen, die einander gegenüberliegend an der Oberseite und an der Unterseite der Leiterplatte positioniert sind, wobei die Sensorelektronik derart ausgebildet ist, dass sie eine Auslenkung des torsions- und biegefähigen Bereiches anhand einer Änderung der Leitungswiderstände der Leiterzüge detektiert.

Vorteilhaft ist die Leiterplatte als mehrschichtige Leiterplatte ausgebildet, wobei zwischen den an der Oberseite und an der Unterseite der Leiterplatte positionierten Leiterzügen zumindest ein weiterer Leiterzug vorgesehen ist. Ist der weitere Leiterzug beispielsweise auf mittlerer Höhe der Flachbaugruppe und damit in der (mechanisch spannungsneutral) spannungstechnisch neutralen Ebene positioniert, so kann dieser beispielsweise zur Temperaturkompensation oder zu sonstigen Diagnosezwecken herangezogen werden. Alternativ oder zusätzlich können weitere Leiterzüge zur Abschirmung herangezogen werden, da die zu erwartenden Signale relativ gering sind.

Gemäß einer Ausgestaltung der vorliegenden Erfindung ist ein Sensor in Form eines einzelnen Leiterzugs an der Leiterplatte angeordnet, wobei die Sensorelektronik derart ausgebildet ist, dass sie eine Auslenkung des torsions- und biegefähigen Bereiches anhand eines elektrischen Kontaktschlusses des Leiterzugs mit einem außerhalb der Flachbaugruppe angeordneten elektrischen Leiter oder in Form eines Lösens eines elektrischen Kontaktschlusses des Leiterzugs mit einem außerhalb der Flachbaugruppe angeordneten elektrischen Leiter detektiert. Auf diese Weise wird ein Kontaktschalter realisiert.

Gemäß noch einer weiteren Ausgestaltung der vorliegenden Erfindung ist ein Sensor in Form von Elektroden vorgesehen, die im Abstand zueinander beide an der Leiterplatte angeordnet sind, bevorzugt an starren Bereichen der Leiterplatte, insbesondere entweder an der Oberseite oder an der Unterseite der Leiterplatte, oder eine Elektrode an der Leiterplatte und die andere Elektrode außerhalb der Leiterplatte angeordnet ist, wobei die Sensorelektronik derart ausgebildet ist, dass sie eine Auslenkung des torsions- und biegefähigen Bereiches anhand einer Änderung des elektrischen Feldes zwischen den Elektroden detektiert. Auf diese Weise wird ein kapazitiver Sensor realisiert.

Ferner ist es erfindungsgemäß möglich, einen Sensor in Form von Spulen vorzusehen, die beide im Abstand zueinander an der Leiterplatte angeordnet sind, insbesondere entweder an der Oberseite oder an der Unterseite der Leiterplatte, oder eine Spule an der Leiterplatte und die andere Spule außerhalb der Leiterplatte angeordnet ist, wobei die Sensorelektronik derart ausgebildet ist, dass sie eine Auslenkung des torsions- und biegefähigen Bereiches anhand einer Änderung des magnetischen Feldes zwischen den Spulen detektiert. Auf diese Weise wird ein induktiver Sensor realisiert.

Ferner schafft die vorliegende Erfindung zur Lösung der eingangs genannten Aufgabe eine Flachbaugruppe zur Herstellung eines erfindungsgemäßen Systems, die eine Leiterplatte aus elektrisch isolierendem Material, die auch als ein- oder mehrlagige Leiterplatte ausgebildet sein kann, einer Mehrzahl von aus einem elektrisch leitenden Material hergestellte Leiterbahnen, die an der Leiterplatte angeordnet sind, und wenigstens einen an der Leiterplatte positionierten Sensor aufweist, wobei die Leiterplatte zumindest einen mit Ausnehmungen versehenen, torsions- und biegefähigen Bereich aufweist, und wobei es sich bei dem Material des wenigstens einen Sensors um das elektrisch leitende Material der Leiterbahnen handelt.

Gemäß einer Ausgestaltung der vorliegenden Erfindung ist an der Leiterplatte eine Sensorelektronik angeordnet, die zur Auswertung der von dem wenigstens einen Sensor bereitgestellten Sensorsignale ausgebildet ist, wobei der wenigstens eine Sensor und die Sensorelektronik dazu ausgelegt sind, eine Messgröße zu erfassen, die eine Auslenkung des torsions- und biegefähigen Bereiches aus einer Ausgangsstellung repräsentiert.

Es sollte klar sein, dass die erfindungsgemäße Flachbaugruppe die zuvor im Zusammenhang mit dem erfindungsgemäßen System beschriebenen Merkmale aufweisen kann, weshalb an dieser Stelle auf Wiederholungen verzichtet wird.

Weitere Merkmale und Vorteile der vorliegenden Erfindung werden anhand der nachfolgenden Beschreibung unter Bezugnahme auf die beiliegende Zeichnung deutlich. Darin ist
- FIG 1: eine schematische Seitenansicht eines eine Flachbaugruppe aufweisenden Systems gemäß einer Ausführungsform der vorliegenden Erfindung;
- FIG 2: eine Unteransicht der in FIG 1 dargestellten Flachbaugruppe;
- FIG 3: eine schematische Teil-Seitenansicht der in FIG 1 dargestellten Flachbaugruppe, die Sensoren gemäß einer ersten Ausführungsform der vorliegenden Erfindung zeigt;
- FIG 4: eine schematische Teil-Seitenansicht der in FIG 1 dargestellten Flachbaugruppe analog zu FIG 3, welche Sensoren gemäß einer zweiten Ausführungsform der vorliegenden Erfindung bei einem Multilayer-Aufbau der Flachbaugruppe zeigt;
- FIG 5: eine schematische Teil-Seitenansicht der in FIG 1 dargestellten Flachbaugruppe, die einen Sensor gemäß einer weiteren Ausführungsform der vorliegenden Erfindung zeigt;
- FIG 6: eine schematische Teil-Seitenansicht der in FIG 1 dargestellten Flachbaugruppe, die noch eine weitere Ausführungsform eines erfindungsgemäßen Sensors zeigt;
- FIG 7: eine schematische Draufsicht einer Flachbaugruppe gemäß einer weiteren Ausführungsform der vorliegenden Erfindung und
- FIG 8: eine Seitenansicht der in FIG 7 dargestellten Flachbaugruppe.

Gleiche Bezugsziffern beziehen sich nachfolgend auf gleiche oder gleichartig ausgebildete Bauteile.

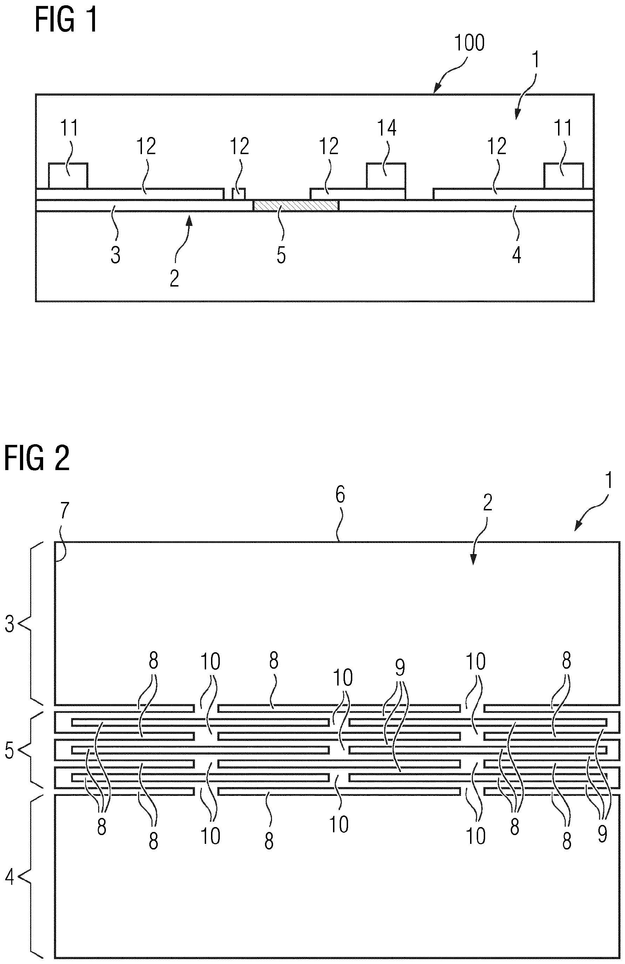

FIG 1 zeigt ein eine Flachbaugruppe 1 aufweisendes System 100 gemäß einer Ausführungsform der vorliegenden Erfindung. Die Flachbaugruppe 1 umfasst eine Leiterplatte 2 aus elektrisch isolierendem Material, beispielsweise aus glasfaserverstärktem Kunststoff. Die Leiterplatte 2 weist vorliegend zwei starre Bereiche 3 und 4 auf, die über einen torsions- und biegefähigen Bereich 5 miteinander verbunden sind, der vorliegend schraffiert dargestellt ist. Wie es in FIG 2 gezeigt ist, erstreckt sich der torsions- und biegefähige Bereich 5 vollständig von einer ersten Seitenkante 6 der Leiterplatte 2 zu einer gegenüber liegenden zweiten Seitenkante 7 der Leiterplatte 2 und umfasst eine Mehrzahl von Ausnehmungen 8. Diese Ausnehmungen 8 bilden vorliegend eine Mehrzahl von Stegen 9 und Zwischenstegen 10. Die Stege 9 erstrecken sich geradlinig zwischen der ersten Seitenkante 6 und der zweiten Seitenkante 7, vorliegend senkrecht zu den Seitenkanten 6 und 7, teilweise fluchtend miteinander und teilweise parallel zueinander. Die Zwischenstege 10 verbinden die Stege 9 miteinander, wobei Gruppen von Zwischenstegen 10 miteinander fluchten. Dank dieser strukturierten Ausnehmungen 8 können die starren Bereiche 3 und 4 relativ zueinander gebogen und tordiert werden. Ferner umfasst die Flachbaugruppe 1 vorliegend mehrere auf den starren Bereichen 3 und 4 der Leiterplatte 2 angeordnete elektronische Bauteile 11 sowie aus einem elektrisch leitenden Material hergestellte Leiterbahnen 12, welche die elektronischen Bauteile 11 miteinander elektrisch verbinden, wobei es sich bei dem elektrisch leitenden Material vorliegend um Kupfer handelt. An dieser Stelle sei darauf hingewiesen, dass elektrische Bauteile 11 nicht zwingend an der Leiterplatte 2 angeordnet sein müssen. Zudem umfasst die Flachbaugruppe 1 wenigstens einen Sensor 13 und zumindest eine Sensorelektronik 14, die zur Auswertung der von dem wenigstens einen Sensor 13 bereitgestellten Sensorsignale ausgebildet ist. Genauer gesagt sind der wenigstens eine Sensor 13 und die Sensorelektronik 14, die vorliegend beide auf der Leiterplatte 2 angeordnet sind, dazu ausgelegt, eine Messgröße zu erfassen, die eine Auslenkung des torsions- und biegefähigen Bereiches 5 der Leiterplatte 2 aus einer Ausgangsstellung repräsentiert. Die Sensorelektronik kann, auch wenn es nicht dargestellt ist, alternativ auch außerhalb der Leiterplatte 2 nahe des wenigstens einen Sensors 13 positioniert sein. Erfindungsgemäß sind der wenigstens eine Sensor 13 und die Leiterbahnen 12 aus demselben elektrisch leitenden Material hergestellt. Vorteilhaft werden die Leiterbahnen 12 und der zumindest eine Sensor 13 in gemeinsamen Verfahrensschritten während der Herstellung der Flachbaugruppe 1 hergestellt, beispielsweise im Rahmen eines vollständigen Beschichtens der Leiterplatte 2 mit Kupfer und eines sich anschließenden selektiven Entfernens der Kupferschicht zur Erzeugung der Leiterbahnen 12 und des zumindest einen Sensors 13, beispielsweise mittels Ätzen, Lasern, Fräsen, Bohren oder dergleichen. Sind mehrere Sensoren 13 vorhanden, werden bevorzugt sämtliche Sensoren 13 gemeinsam mit den Leiterbahnen 12 hergestellt.

Die Figuren 2 bis 6 zeigen verschiedene Varianten erfindungsgemäßer Sensoren 13.

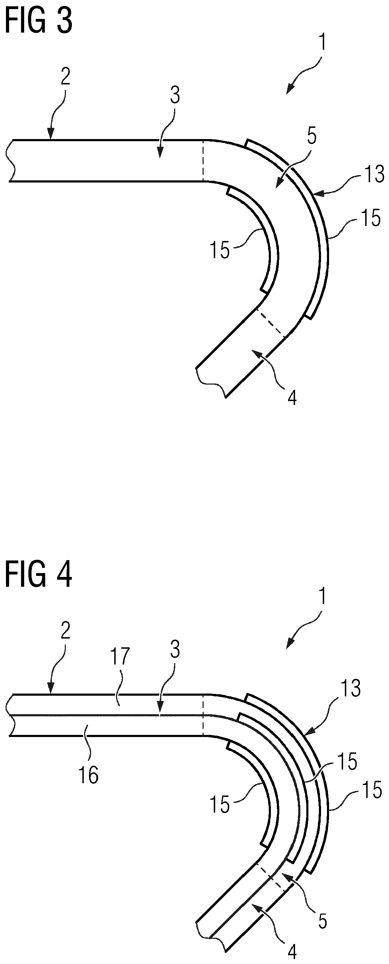

FIG 3 zeigt einen Sensor 13, der innerhalb des torsions- und biegefähigen Bereiches 5 in Form von Leiterzügen 15 vorgesehen sind, die einander gegenüberliegend an der Oberseite und an der Unterseite der Leiterplatte 2 positioniert sind. Die Sensorelektronik 14 ist derart ausgebildet, dass sie eine Auslenkung des torsions- und biegefähigen Bereiches 5 anhand einer Änderung der Leitungswiderstände der Leiterzüge 15 detektiert.

Die in FIG 4 dargestellte Anordnung unterscheidet sich dahingehend von der in FIG 3 dargestellten Anordnung, dass die Leiterplatte 2 mehrschichtig ausgebildet ist, vorliegend aus zwei Leiterplattenschichten 16 und 17, die übereinander angeordnet und aneinander befestigt sind. Neben den beiden in FIG 3 dargestellten Leiterzügen 15 umfasst der Sensor 13 einen dritten Leiterzug 15, der auf der Oberseite oder im Inneren der unteren Leiterplattenschicht 16 im torsions- und biegefähigen Bereich 5 positioniert und sich entlang der mechanisch spannungsneutralen Ebene der Leiterplatte 2 erstreckt. Dieser weitere Leiterzug 15 kann beispielsweise zur Temperaturkompensation oder zu sonstigen Diagnosezwecken herangezogen werden.

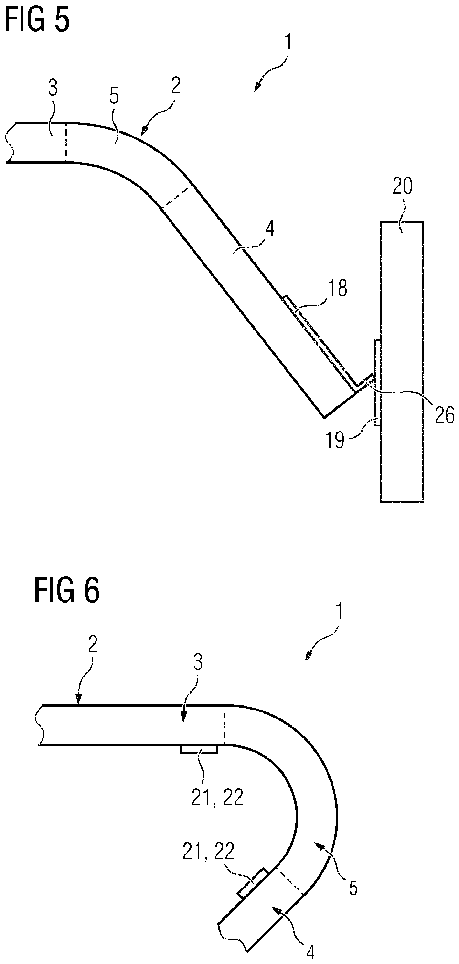

FIG 5 zeigt einen im starren Bereich angeordneten Sensor 13 in Form eines einzelnen Leiterzuges 18, der vorliegend ein von der Oberseite der Flachbaugruppe 1 vorstehendes elektrisch leitendes Endstück angebracht ist. Vorliegend ist die Sensorelektronik 14 derart ausgebildet, dass sie eine Auslenkung des torsions- und biegefähigen Bereiches 5 anhand eines elektrischen Kontaktschlusses des Endstückes des Leiterzugs 18 mit einem außerhalb der Flachbaugruppe 1 angeordneten elektrischen Leiter 19 oder in Form eines Lösens eines elektrischen Kontaktschlusses des Endstückes des Leiterzugs 18 mit dem außerhalb der Flachbaugruppe 1 angeordneten elektrischen Leiter 19 detektiert, der durch eine Bewegung des torsions- und biegefähigen Bereiches 5 und des mit diesem fest verbundenen starren Bereiches 4 ausgehend aus einer Ruhelage hervorgerufen wird. Der elektrische Leiter 19 kann beispielsweise an einem Maschinengehäuse 20 oder dergleichen positioniert sein.

FIG 6 zeigt Sensoren 13, die in Form von Elektroden 21 oder Spulen 22 vorgesehen sind. Die Elektroden 21 oder Spulen 22 sind im Abstand zueinander an den beiden starren Bereichen 3 und 4 positioniert, vorliegend jeweils an der Unterseite der Leiterplatte 2, wobei die Sensorelektronik 14 derart ausgebildet ist, dass sie eine Auslenkung des torsions- und biegefähigen Bereiches 5 anhand einer Änderung des elektrischen Feldes zwischen den Elektroden 21 bzw. eine Änderung des magnetischen Feldes zwischen den Spulen 22 detektiert. Elektroden 21 oder Spulen 22 können aber auch analog zu FIG 5 angeordnet werden, also jeweils einmal an der Flachbaugruppe 1 und einmal an einer Position außerhalb der Flachbaugruppe 1.

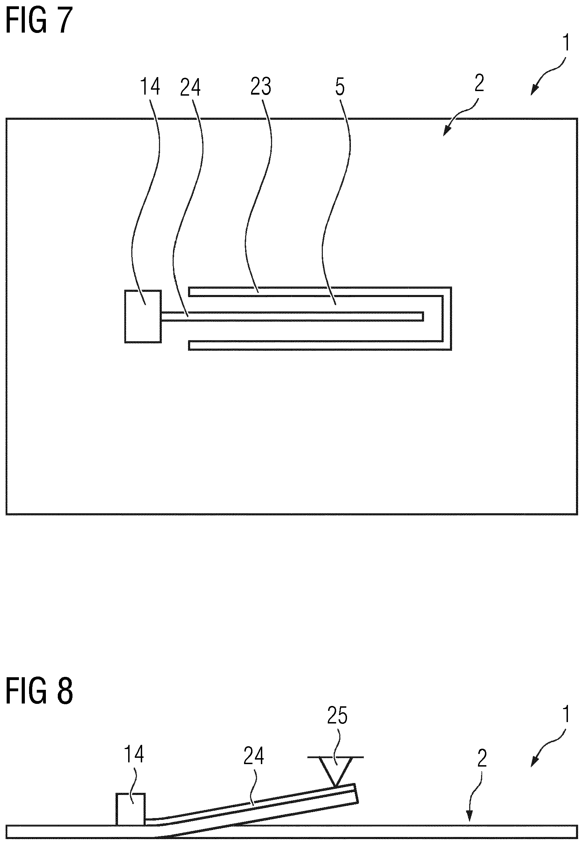

Die Figuren 7 und 8 zeigen eine Flachbaugruppe 1 gemäß einer weiteren Ausführungsform der vorliegenden Erfindung. Bei dieser Flachbaugruppe 1 ist der torsions- und biegefähige Bereich 5 durch eine U-förmige Ausnehmung 23 gebildet, wobei sich ein Sensor 13 in Form eines Leiterzugs 24 von der Auswerteelektronik 14 in den torsions- und biegefähigen Bereich 5 erstreckt. Die Sensorelektronik 14 ist derart ausgebildet, dass ihr eine Auslenkung des torsions- und biegefähigen Bereiches 5 anhand eines elektrischen Kontaktschlusses des Leiterzugs 24 mit einem außerhalb der Flachbaugruppe 1 angeordneten elektrischen Leiter 25 oder in Form eines Lösens eines elektrischen Kontaktschlusses des Leiterzugs 24 mit dem außerhalb der Flachbaugruppe 1 angeordneten elektrischen Leiter 25 detektiert.

Die erfindungsgemäße Flachbaugruppe 1 hat den Vorteil, dass zur Anordnung von Sensoren 13 auf den Einsatz herkömmlicher Standardbauteile verzichtet werden kann. Die Sensoren 13 werden zusammen mit den Leiterbahnen 12 hergestellt. Entsprechend können bei der Herstellung der Flachbaugruppe 1 Arbeitsschritte entfallen. Auch wird die Variantenvielfalt an Bauteilen reduziert, wodurch Abhängigkeiten von Zulieferern minimiert und die Kosten gesenkt werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. System (100) umfassend eine Flachbaugruppe (1), die eine Leiterplatte (2) aus elektrisch isolierendem Material, die auch als ein- oder mehrlagige Leiterplatte ausgebildet sein kann, einer Mehrzahl von aus einem elektrisch leitenden Material hergestellte Leiterbahnen (12), die an der Leiterplatte (2) angeordnet sind, und wenigstens einen an der Leiterplatte (2) positionierten Sensor (13) aufweist, und zumindest eine Sensorelektronik (14), die zur Auswertung der von dem wenigstens einen Sensor (13) bereitgestellten Sensorsignale ausgebildet ist, wobei die Leiterplatte (2) zumindest einen mit Ausnehmungen (8) versehenen, torsions- und biegefähigen Bereich (5) aufweist, und wobei der wenigstens eine Sensor (13) und die Sensorelektronik (14) dazu ausgelegt sind, eine Messgröße zu erfassen, die eine Auslenkung des torsions- und biegefähigen Bereiches (5) aus einer Ausgangsstellung repräsentiert, **dadurch gekennzeichnet , dass** es sich bei dem Material des wenigstens einen Sensors (13) um das elektrisch leitende Material der Leiterbahnen (12) handelt.

2. System (100) nach Anspruch 1, **dadurch gekennzeichnet, dass** sich der torsions- und biegefähige Bereich (5) von einer ersten Seitenkante (6) der Leiterplatte (2) zu einer gegenüberliegenden zweiten Seitenkante (7) der Leiterplatte (2) erstreckt, insbesondere vollständig von einer ersten Seitenkante (6) der Leiterplatte (2) zu einer gegenüberliegenden zweiten Seitenkante (7) der Leiterplatte (2).

3. System (100) nach Anspruch 2, **dadurch gekennzeichnet, dass** die Ausnehmungen (8) eine Mehrzahl sich geradlinig zwischen der ersten Seitenkante (6) und der zweiten Seitenkante (7), insbesondere senkrecht zu diesen, teilweise fluchtend miteinander und teilweise parallel zueinander erstreckenden Stegen (9) bilden, die über Zwischenstege (10) miteinander verbunden sind, wobei Gruppen von Zwischenstegen (10) miteinander fluchten.

4. System (100) nach einem der vorhergehenden Ansprüche,
**dadurch gekennzeichnet, dass** innerhalb des torsions- und biegefähigen Bereiches (5) ein Sensor (13) in Form von Leiterzügen (15) vorgesehen ist, die einander gegenüberliegend an der Oberseite und an der Unterseite der Leiterplatte (2) positioniert sind, wobei die Sensorelektronik (14) derart ausgebildet ist, dass sie eine Auslenkung des torsions- und biegefähigen Bereiches (5) anhand einer Änderung der Leitungswiderstände der Leiterzüge (15) detektiert.

5. System (100) nach Anspruch 4, **dadurch gekennzeichnet, dass** die Leiterplatte (2) mehrschichtig ausgebildet ist, und dass zwischen den an der Oberseite und an der Unterseite der Leiterplatte (2) positionierten Leiterzügen (15) zumindest ein weiterer Leiterzug (18) vorgesehen ist.

6. System (100) nach einem der vorhergehenden Ansprüche,
**dadurch gekennzeichnet , dass** ein Sensor (13) in Form eines einzelnen Leiterzugs (18) an der Leiterplatte (2) angeordnet ist, wobei die Sensorelektronik (14) derart ausgebildet ist, dass sie eine Auslenkung des torsions- und biegefähigen Bereiches (5) anhand eines elektrischen Kontaktschlusses des Leiterzugs (18) mit einem außerhalb der Flachbaugruppe (1) angeordneten elektrischen Leiter (19) oder in Form eines Lösens eines elektrischen Kontaktschlusses des Leiterzugs (18) mit einem außerhalb der Flachbaugruppe (1) angeordneten elektrischen Leiter (19) detektiert.

7. System (100) nach einem der vorhergehenden Ansprüche,
**dadurch gekennzeichnet, dass** ein Sensor (13) in Form von Elektroden (21) vorgesehen ist, die beide im Abstand zueinander an der Leiterplatte (2) angeordnet sind, bevorzugt an starren Bereichen (3, 4) der Leiterplatte (2), insbesondere entweder an der Oberseite oder an der Unterseite der Leiterplatte (2), oder eine Elektrode (21) außerhalb der Leiterplatte (2) angeordnet ist, wobei die Sensorelektronik (14) derart ausgebildet ist, dass sie eine Auslenkung des torsions- und biegefähigen Bereiches (5) anhand einer Änderung des elektrischen Feldes zwischen den Elektroden (21) detektiert.

8. System (100) nach einem der vorhergehenden Ansprüche,
**dadurch gekennzeichnet, dass** ein Sensor (13) in Form von Spulen (22) vorgesehen ist, die beide im Abstand zueinander an der Leiterplatte (2) angeordnet sind, insbesondere entweder an der Oberseite oder an der Unterseite der Leiterplatte (2), oder eine Spule (22) an der Leiterplatte (2) und die andere Spule (22) außerhalb der Leiterplatte (2) angeordnet ist, wobei die Sensorelektronik (14) derart ausgebildet ist, dass sie eine Auslenkung des torsions- und biegefähigen Bereiches (5) anhand einer Änderung des magnetischen Feldes zwischen den Spulen (22) detektiert.

9. System (100) nach einem der vorhergehenden Ansprüche,
**dadurch gekennzeichnet, dass** die Sensorelektronik (14) an der Leiterplatte (2) angeordnet ist.

10. System (100) nach einem der vorhergehenden Ansprüche,
**dadurch gekennzeichnet, dass** an der Leiterplatte (2) mit Leiterbahnen (12) elektrisch verbundene elektronische Bauteile (11) befestigt sind.

11. Flachbaugruppe (1) zur Herstellung eines Systems (100) nach einem der vorhergehenden Ansprüche, die eine Leiterplatte (2) aus elektrisch isolierendem Material, die auch als ein- oder mehrlagige Leiterplatte ausgebildet sein kann, einer Mehrzahl von aus einem elektrisch leitenden Material hergestellte Leiterbahnen (12), die an der Leiterplatte (2) angeordnet sind, und wenigstens einen an der Leiterplatte (2) positionierten Sensor (13) aufweist, wobei die Leiterplatte (2) zumindest einen mit Ausnehmungen (8) versehenen, torsions- und biegefähigen Bereich (5) aufweist, und wobei es sich bei dem Material des wenigstens einen Sensors (13) um das elektrisch leitende Material der Leiterbahnen (12) handelt.

12. Flachbaugruppe (1) nach Anspruch 11, **dadurch gekennzeichnet, dass** an der Leiterplatte (2) eine Sensorelektronik (14) angeordnet ist, die zur Auswertung der von dem wenigstens einen Sensor (13) bereitgestellten Sensorsignale ausgebildet ist, wobei der wenigstens eine Sensor (13) und die Sensorelektronik (14) dazu ausgelegt sind, eine Messgröße zu erfassen, die eine Auslenkung des torsions- und biegefähigen Bereiches (5) aus einer Ausgangsstellung repräsentiert.
